# EUROPEAN PATENT APPLICATION

(11) **EP 2 722 893 A1**
(43) Date of publication of application: **23.04.2014**
(21) Application number: 13188852.1
(22) Date of filing: 16.10.2013
(51) Int. Cl.: H01L 29/78, H01L 21/285, H01L 29/66, H01L 29/417

(54) **Finfet device with silicided source-drain regions and method of making same using a two step anneal**

(30) Priority: 16.10.2012 US 201261714334 P; 10.10.2013 US 201314051174
(71) Applicant: STMicroelectronics (Crolles 2) SAS, 38926 Crolles Cedex (FR); STMicroelectronics, Inc., Coppell, TX 75019 (US)
(72) Inventor: Morin, Pierre, Albany, NY New York 12208 (US); Beneyton, Remi, 38100 Grenoble (FR)
(74) Representative: Style, Kelda Camilla Karen

(57) **Abstract**

A thermal annealing flow process includes the steps of: depositing a metal or metal alloy on a silicon semiconductor structure, performing a first annealing of a rapid thermal anneal (RTA) type to produce a metal rich phase in a portion of the silicon semiconductor structure, removing unreacted metal or metal alloy and performing a second annealing as a millisecond annealing at a temperature that is below a melt temperature of the silicon material present in the silicon semiconductor structure.

## Description

### TECHNICAL FIELD

Some embodiments relate to the formation of silicides and, more particularly, to the formation of silicided source-drain regions of field effect transistor (FET) devices and, even more particularly, to the fabrication of FinFET devices having fully silicided strained source-drain regions.

### BACKGROUND

Stress may be introduced in field effect transistors (FETs) along conducting channels to enhance carrier mobility. To meet the continuing demand in the microelectronic industry for high drive current and increased circuit speed, strained silicon (Si) channels are of particular interest in order to improve performance of FETs and FET-containing devices. However, the ability to increase stress along the Si channel has proven to be challenging. Current fabrication processes are either extremely complex or have been found to reduce efficiency of the FET and the FET-containing device.

There remains a need to provide improved devices and methods of fabricating such devices that satisfy the industry requirements for increased circuit speed and improved performance of advanced microelectronics. The improved devices and method of fabricating such devices should not offer additional complexity to the flow process and should not reduce the efficiency of the final product when formed.

Silicides minimize the contact resistance between a silicon source-drain region (SDR) and the contact of electronic devices like complementary metal oxide semiconductor field effect transistors (CMOSFET). Since the advent of the 90 and 65 nm nodes, nickel silicides are the standard of the CMOSFET industry for contacting with the formation of the low resistivity mono-silicide NiSi phase to minimize the contact resistance. One industry practice is adding platinum to nickel to enhance the silicide thermal stability, to delay the NiSi agglomeration and the di-silicide NiSi₂ or other Si-rich phase formation. Ni(Pt)Si also reduces defect contents such as encroachment or piping under the CMOSFET gate. From the older to the most advanced technology nodes, Pt content varies in proportion from 0 to 15 %, respectively.

Improved processes for silicidation are needed as FET transistor fabrication moves towards new structures such as with FinFET devices.

### SUMMARY

According to an embodiment there is provided a process, comprising: depositing a metal or metal alloy on a silicon-containing material; thermally annealing at a first temperature; removing unreacted metal or metal/alloy; and thermally annealing at a second temperature and for a duration less than 30 milliseconds, wherein the second temperature is greater than the first temperature, and wherein the second temperature is a sub-melt temperature below a melt temperature of the silicon containing material.

Thermally annealing at the first temperature may form a metal rich phase in a portion of the silicon containing material.

Thermally annealing at the second temperature may form a metal mono-silicide in the silicon containing material.

The first temperature may be between about 250 °C and about 320° C and the second temperature may be in excess of 650° C but below the melt temperature of the silicon containing material.

The silicon-containing material may be a source-drain region of a transistor.

Depositing may comprise depositing a thin layer of the metal or metal alloy.

The thermal annealing at the second temperature has a duration of less than 20 milliseconds.

The thermal annealing at the second temperature may have a duration of less than 10 milliseconds.

The thermal annealing at the second temperature may have a duration of about 1 millisecond to as low as 0.2 milliseconds.

Thermally annealing at a second temperature and for a duration less than 30 milliseconds may comprise performing a millisecond sub-melt laser anneal.

Thermally annealing at a first temperature may comprise performing a rapid thermal anneal (RTA).

Thermally annealing at a second temperature and for a duration less than 30 milliseconds may comprise performing a dynamic scanning anneal.

According to another embodiment there is provided a process, comprising: forming a silicon semiconductor structure supporting a source-drain region of a transistor; forming a gate structure, said source-drain region provided in association with said gate structure; siliciding said source-drain region by:depositing a metal or metal alloy on said source-drain region; performing a first annealing at a first temperature; removing unreacted metal or metal alloy from the source-drain region; and performing a second annealing at a second temperature that is greater than the first temperature but below a melt temperature of said silicon semiconductor structure, said second annealing having a duration not exceeding 30 milliseconds.

The silicon semiconductor structure may be a fin of a FinFET transistor.

The silicon semiconductor structure may comprise silicon-germanium.

Performing the first annealing may form a metal rich phase in a portion of the silicon semiconductor structure.

Performing the second annealing may form a metal mono-silicide in the silicon semiconductor structure.

The source-drain region may be fully silicided.

The first temperature may be between about 250° C and about 320° C and the second temperature may be in excess of 650° C but below the melt temperature of the silicon semiconductor structure.

In another embodiment, a process comprises: depositing a metal or metal alloy on a silicon-containing material; thermally annealing at a first temperature; removing unreacted metal or metal/alloy; and thermally annealing at a second temperature and for a duration less than 30 milliseconds, wherein the second temperature is greater than the first temperature, and wherein the second temperature is a sub-melt temperature below a melt temperature of the silicon containing material.

In an embodiment, a process comprises: forming a silicon semiconductor structure supporting a source-drain region of a transistor; forming a gate structure, said source-drain region provided in association with said gate structure; and siliciding said source-drain region by: depositing a metal or metal alloy on said source-drain region; performing a first annealing at a first temperature; removing unreacted metal or metal alloy from the source-drain region; and performing a second annealing at a second temperature that is greater than the first temperature but below a melt temperature of said silicon semiconductor structure, said second annealing having a duration not exceeding 30 milliseconds.

In one or more embodiments, a process for fabricating integrated circuit structures (FETs, FinFETs, complementary metal oxide semiconductors (CMOS) and the like) is provide with respect to the formation of silicides and in particular silicided source-drain regions. The process includes depositing a metal or metal alloy followed by performing an improved two step thermal anneal. The metal may include but is not limited to a transition metal, such as nickel (Ni), titanium (Ti), cobalt (Co), and the metal alloy may include such a transition metal, for example nickel containing platinum [Ni(Pt)].

The two step anneal includes a first anneal and a second anneal. The first anneal is performed at a first temperature that for example, is generally selected for use with a standard known (conventional) RTA methods. In one or more embodiments, the first temperature is between about 250 °C and about 320° C. In some embodiments, the first temperature is about 300° C. The second thermal annealing is a millisecond anneal performed at a higher temperature than the first anneal but below the melt temperature of Si. The second thermal anneal is performed for a short duration that is about or less than about 30 milliseconds, or less than 20 milliseconds, or less than 10 milliseconds, and or about 1 millisecond or less than 1 millisecond or as low as about 0.2 milliseconds. The second thermal anneal may be performed by laser annealing or by a dynamic surface annealing (DSA) or the like. In one or more embodiments, the second temperature is between about 650° C and about 850° C. In one or more embodiments, the second temperature is about 800° C.

The flow process results in formation of a metal mono-silicide. For metals represented by nickel (Ni), titanium (Ti), cobalt (Co), and nickel containing platinum [Ni(Pt)], the metal mono-silicide that will be formed by the flow process described is NiSi, TiSi₂, CoSi₂, and Ni(Pt)Si, respectively.

The flow process may be performed before or after gate formation of a FET, FinFET, CMOSFET, and the like.

### BRIEF DESCRIPTION OF THE DRAWINGS

For a better understanding of the embodiments, reference will now be made by way of example only to the accompanying figures in which:

FIG. 1 depicts a flow process described herein;

FIG. 2 depicts thermal-stress hysteresis measurements;

FIG. 3 depicts representative stress values produced using a conventional process (triangle) as compared with the described process (circle);

FIG. 4 depicts thermal-stress hysteresis measurements for wafers subjected to a conventional process (triangle) as compared with the described process (circle)

FIG. 5 depicts schematically a representative structure subjected to a process described herein after which the structure was fully integrated;

FIG. 6A depicts representative strain measurements using a conventional process;

FIG. 6B depicts representative strain measurements using the described flow process;

FIG. 7 depicts representative strain values after fitting experimental data obtained from a described process using a finite element simulation; and

FIGS. 8-20 depict schematically another representative flow process described herein.

### DETAILED DESCRIPTION OF THE DRAWINGS

Although making and using various embodiments are discussed in detail below, it should be appreciated that as described herein are provided many inventive concepts that may be embodied in a wide variety of contexts. Embodiments discussed herein are merely representative and do not limit the scope of the invention.

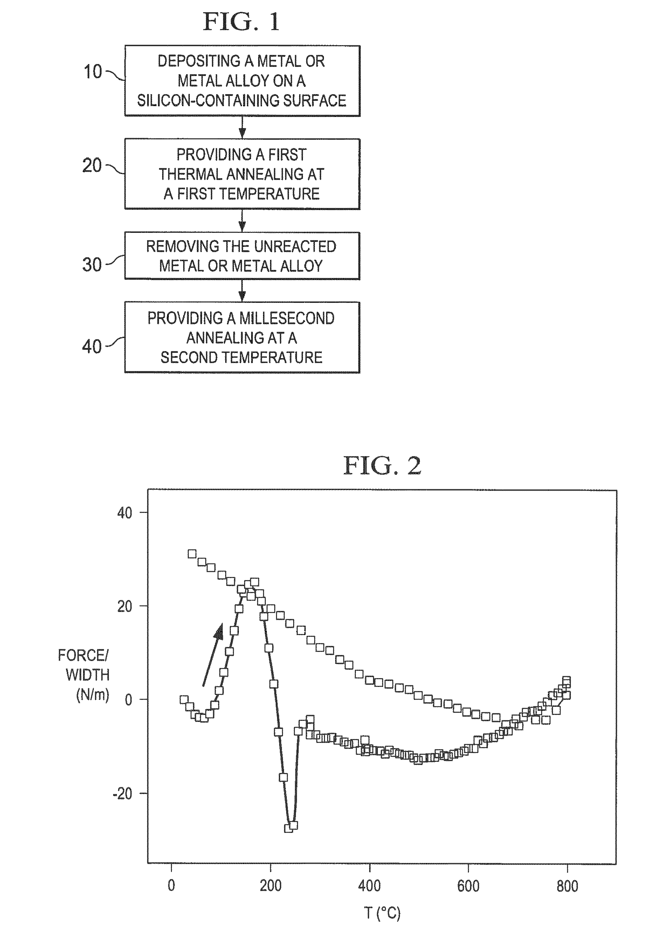

Reference is now made to FIG. 1 which illustrates a flow process for silicidation.

Step 10 provides for depositing a metal or a metal alloy on a Si containing surface. Suitable metals for deposition include transitional metals as well as metal alloys of transitional metals. Examples include, but are not limited to, the use of the following metals: Ni, Ti, and Co, as well as an alloy of Ni(Pt). It is understood that other suitable metal and metal alloys are also acceptable and will be known to those skilled in the art. The metal deposition thickness is generally between about 1 nm and about 30 nm or between about 3 nm and about 25 nm.

The process continues with the performance of a two-step thermal anneal.

The two-step thermal anneal process includes a first thermal annealing (step 20) and a second thermal annealing (step 40). In between the two anneals, unreacted metal previously deposited in step 10 but not converted to silicide in step 20 is removed.

In the first thermal anneal, the Si containing surface on which the metal or metal alloy has been deposited is subjected to a first thermal annealing at a first temperature and a first duration. The first temperature is considered a low annealing temperature. In one or more embodiments, the first temperature is between about 250 °C and about 320° C. In some embodiments, the first temperature is about 300 °C. The duration of the first thermal anneal is typically provided in the range of about 10 seconds and about 120 seconds. This first thermal annealing initiates diffusion of the metal or metal alloy in the Si containing surface, forming a metal rich phase. For example, with deposition of a Ni(Pt) alloy, a Pt doped nickel-rich phase is formed in the Si containing surface.

After completion of the step 20 first anneal, un-reacted metal or metal alloy is removed using a wet chemical etch (which may be selective of the previously deposited metal if desired).

In the second thermal anneal, the partially silicided Si surface on which the metal or metal alloy was previously deposited and from which unreacted metal has been removed, is subjected to a second thermal annealing at a second temperature and a second duration. The second temperature considered a high temperature that is greater than the first temperature of the first thermal annealing. In one or more embodiments, the second temperature is a sub-melt temperature that may achieve a high device temperature but does not melt Si. In one or more embodiments, the second temperature is between about 650° C and about 850° C. The duration of exposure to the second temperature is very short, typically 30 milliseconds or less, and is referred to herein as a millisecond anneal. In some embodiments, the duration may only be at or about 1 millisecond. In additional embodiments, the duration may be as low as 0.2 millisecond. In some embodiments, the second duration may be between about 1 millisecond and about 30 milliseconds. In further embodiments, the second duration may be between about 0.2 millisecond and about 30 milliseconds. This short duration is desired so as to prevent diffusion of the metal or metal alloy from the metal-rich phase. The shortness of the second thermal annealing further prevents stress relaxation and inhibits significant dopant deactivation. It is undesirable for the duration of the second thermal annealing to be longer than 30 milliseconds because it does not provide a desired transformation. When the second thermal annealing is longer than 30 milliseconds, it is no longer considered a millisecond annealing, and instead is considered to be a conventional rapid thermal anneal (RTA) process.

The millisecond anneal may be performed by laser annealing or by a dynamic surface annealing. The second thermal annealing transforms the metal rich phase (formed in the first thermal annealing) into a metal mono-silicide. For example, when the metal rich phase is a Ni-rich phase formed with the first annealing, the second thermal annealing will form a nickel mono-silicide. A short pulse laser may be used for the second thermal annealing; this tool is compatible with processing of CMOSFETs and FinFETs.

Advantageously, with the flow process described, there is no silicide agglomeration or formation of a Si-rich phase. This is due, in part, to the fact that the second thermal annealing is a millisecond annealing, such that the duration of the second thermal annealing is limited to 30 seconds or less.

As understood by those skilled in the art, selection of the metal for the silicidation has an effect on the tensile stress provided to the Si containing surface after completion of the described flow process.

When the described flow process is complete, the region of the Si-containing surface to which the metal is deposited will, in a preferred embodiment, be fully converted to silicide. For example, with use of a metal or metal alloy, such as Ni, Ti, Co, and an alloy of Ni(Pt), the silicide formed will be NiSi, TiSi₂, CoSi₂, and Ni(Pt)Si, respectively.

The flow process described was examined on p-type (001) silicon wafers and on SDR electrical wafers of 28 nm node as described below.

Initially, thermal annealing was analyzed on a full sheet wafer sample. A (001) p-type doped silicon substrate underwent an *in-situ* pre-clean after which a 10 nm thick layer of Ni(Pt) (in which Pt was 10%) was introduced at 20° C via physical vapor deposition (PVD).

The stress hysteresis on the full wafer sheet after Ni(Pt) deposition is shown in FIG. 2. Stress developed above 130° C because of grain growth in the Ni film. The stress shifted to compressive values during formation of the metal rich phase, which in this case was a Ni-rich silicide phase of Ni₂Si. The minimum value around 300° C was related to a full diffusion of the Ni layer in Si. The increase to more tensile values corresponded to the relaxation of the stress within the Ni-rich phase. Above 300° C, the formation of the metal mono-silicide, in this case, as Ni mono-silicide, occurred in parallel to the relaxation of the stress within the layer; the force to width ratio was close to 0. Because of the addition of Pt, a di-silicide formation was not expected along the cycle, even at 800° C. During the cooling from 800° C to 650° C, the force to width ratio σ *x_{f}* was plotted and remained small and presented as a slightly negative slope. This trend was similar to the findings during the temperature ramp-up in the same range. Below 650° C, a somewhat linear build-up of σ *x_{f}* to a positive value was observed until room temperature was reached, with a brief inflection at 400° C due to the difference in coefficient of thermal expansion of silicide versus silicon. At the end of the thermal cycle, a stress value at room temperature of 800 MPa was measured for the full wafer sheet on which the Ni(Pt) was deposited. The stress value measured is consistent with a tensile stress value measured for NiSi and for Ni(Pt)Si (with 10% Pt), which ranged from 600 and 850 MPa, when prepared by standard (conventional) annealing methods that used an annealing temperature of about 400 °C and an anneal duration of 30 seconds.

Example of the flow process on full sheet wafers.

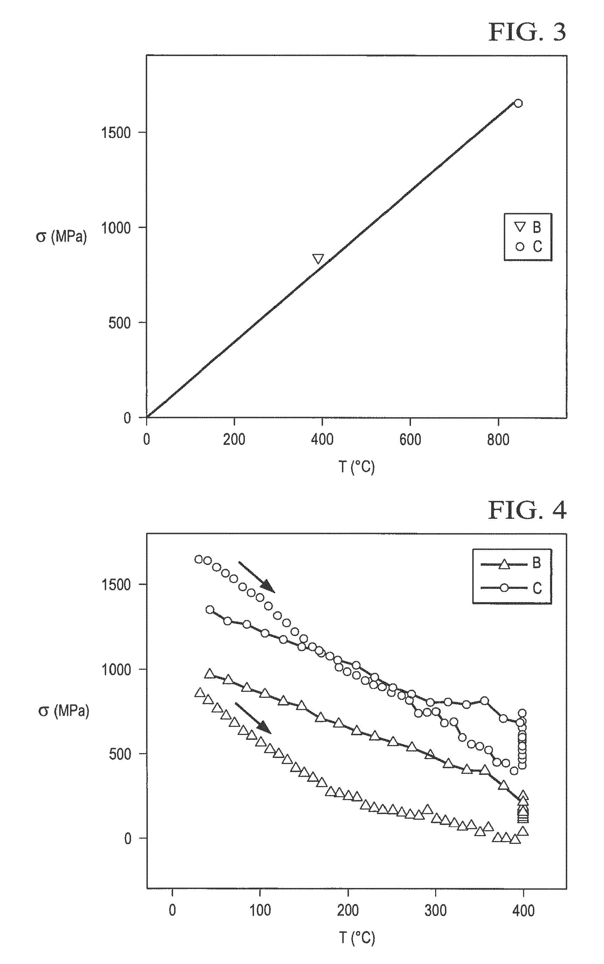

To a number of p-type (001) silicon wafers, a bi-layer of Ni(Pt) (with 10% Pt)/TiN was deposited at 20° C via PVD forming respective thicknesses of 10 nm and 10 nm. All the wafers were thermally annealed at a first temperature of 280° C using a standard RTA method with halogen lamps under nitrogen for 30 seconds, after which the un-reacted metal stack was removed by selective wet etching. To some of the wafers, used as control samples, a second annealing was performed at 390° C for 30 seconds (thereby applying a standard RTA method. To other wafers undergoing the flow process described herein, a millisecond annealing was performed at 800 ° C for a duration of 0.5 millisecond. These latter wafers presented a stress value of 1.65 GPa as compared to the control samples that presented a stress value of 800 MPa (FIG. 3). The straight dotted line in FIG. 3 depicts the linear dependence of the stress with temperature. For both structures, the stress was obtained at room temperature after the metal silicide was formed. The results show that the stress value will more than double when a wafer is subjected to the flow process described herein. The produced stress is also more or less stable, even after further processing, as depicted in the hysteresis data provided below (FIG. 4).

Thermal stability of the wafers and the silicide (Ni(Pt)Si) formed after processing by both the standard (conventional) method (wafer B) and the flow process described herein (wafer C) were evaluated by subjecting each to *in-situ* curvature measurements, using the methodology described above. The hysteresis included a ramp up (5 °C /min) from room temperature to 400 °C and included a 1 hour plateau at the top temperature of 400 °C. Representative results are illustrated in FIG. 4. For both wafer B and wafer C, there was a decrease in thermal stress for temperatures from room temperature to 400 °C due, in part, to a difference in dilatation coefficient between the silicon and the silicide and also to a mismatch between the silicon and metal silicide coefficients of thermal expansion (CTE). Stress increased in both wafer structures during the 400 °C plateau. With cooling, there was an observed thermal stress build-up (with a lower slope), which was significantly higher for the wafer that underwent the flow process described herein (wafer C), indicating a slight material transformation. The stress was measured again at room temperature following the wafer curvature measurements after ramp-down. For wafer B, the room temperature stress after the ramp down was 850 MPa, which indicated a positive increase in stress after thermal cycling of about 50 MPa. For wafer C, the room temperature stress after the ramp down was about 1.4 MPa, which indicated a decrease in stress after thermal cycling stress of about 250 MPa. However, despite the stress reduction found in wafer C, this wafer structure remained highly tensile after undergoing the improved annealing flow process described herein, exhibiting a far higher final tensile stress value as compared with wafer B, which had undergone the standard (conventional) RTA method.

Example of the flow process on electrical wafers having source-drain regions (SDR).

Prior to fully integrating, the flow process described was applied to SDR wafers of 28 nm node by depositing Ni(Pt) (with 10% Pt), annealing at a first temperature of 280° C for a duration of 30 seconds, after which the un-reacted metal stack was removed by selective wet etching, followed by a millisecond annealing at 800° C for a duration of 0.5 millisecond. The SDR wafer was then fully integrated as an n-type MOSFET, including formation of copper interconnections, which meant that the SDR wafer was further subjected to thermal treatment at a temperature of about 400° C. A control included the same structure to which was deposited Ni(Pt) (with 10% Pt) followed by annealing at 280° C for a duration of 30 seconds, followed by removal the un-reacted metal stack by selective wet etching, and annealing by a conventional (standard) RTA method at 390° C for 30 seconds. This wafer was also fully integrated in the same manner. The control SDR structure (wafer D) and the wafer which was silicided by the described flow process (wafer E) were both evaluated for silicide thickness, electrical measurements and stress.

Stress was measured for structure D and structure E by measuring strain induced in the silicon SDR using dark field electron holography (DFEH) with a transmission electron microscope (TEM). In each of structure D and structure E, A 120 nm thick TEM lamella was prepared by ion beam milling with a FEI HELIOS dual beam operating at 30 keV. After forming the lamella, a low energy "clean up" beam was applied at 5 keV to remove the amorphous parts full of defects (present on both sides of the lamella). DFEH TEM analysis was then performed within a FEI TECNAI microscope operating at 200 keV with a specific optimization to acquire low level of strain (a bi-prism principle, which is known in the art). After acquisition, the dark field holograms were processed. Maps of the horizontal strain εₓₓ were obtained combining two non-colinear dark field holograms (one from the <202> diffraction spot and the other one from the <-202> diffraction spot). This provided a deformation map on small fields (less than 1000 nm²) compatible with microelectronic scales with a spatial resolution around 8 nm and a strain sensitivity down to 10⁻³ with an accuracy of +/- 5 10⁻⁴. To determine the stress in the silicided nano structure, the experimental silicon strain εₓₓ (measured under the silicide region) was compared with strain profiles obtained with mechanical simulation (using FEM) for different silicide stress values with an accuracy of +/- 0.18 GPa on the stress.

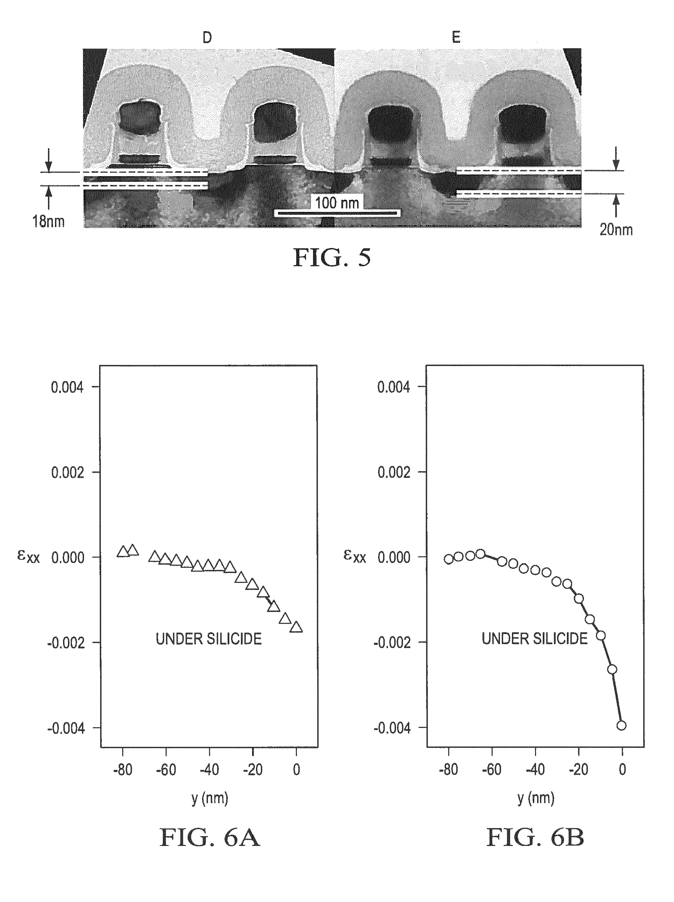

With reference to FIG. 5, microscopic analysis of TEM cross sections showed that both structure D and structure E were fully silicided on the source/drain regions. The average thickness was approximately 18 nm thick for structure D and 20 nm thick for structure E. Thus, the silicided layer thickness was slightly higher with the described flow process. This was not observed with a blanket wafer (full sheet) described above.

Under the silicided regions, a higher compressive horizontal strain component εₓₓ was observed (see wafer C) suggesting a higher stress build-up with the described flow process. The silicon strain below the silicide region was higher for structure E as compared with structure D. Silicidation by the flow process described herein provided the higher tensile strain. This suggests that the increase in the induced strain in structure E is because of a higher stress build up in structure E.

Comparison of the measured silicon strain eₓₓ under the silicide region with strain profiles obtained by simulation for different silicide stress values in the same region allowed for a determination of the stress value in the nano-silicide regions for structure D and structure E. For structure D, the silicide stress estimation was 0.6 GPa +/- 0.18. For structure E, a value of 1.5 GPa +/- 0.18 was obtained. This confirms on first order the effect of the flow process described herein, which includes the millisecond annealing step, because silicide stresses at the nanometer scale are similar to the macroscopic values obtained on the full sheet wafers. The thermal stability was also verified at the nanometer scale because the silicide stress remained highly tensile despite the integration of the metallic inter-connection, which included a significant thermal budget.

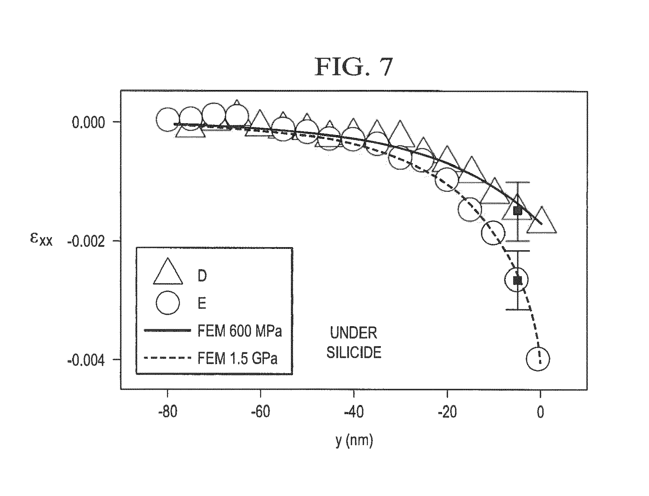

Mechanical simulations calibrated with strained silicon measurements (as described above) when obtained under the silicided regions (FIG. 7) provide the strain field in the silicon channel for both structure D (triangle and solid line) and structure E (circle and dashed line) (FIG. 7). The data shows that the difference calculated between structure D and structure E is below the measurement accuracy. The combination of the DFEH measurements and mechanical FEM simulations at the nanometer scale confirmed that high silicide stress was achieved with the flow process and millisecond annealing described herein.

Thus, the flow process described herein, evaluated macroscopically and at the nanometer scale, provided a metal mono-silicide layer on a Si-containing surface. The flow process described herein also provided a higher tensile stress in the metal mono-silicide, which was maintained even after fully integrating a transistor device. Thus, the higher tensile stress was stable, even after submitting a structure to subsequent inter-connection heatings and coolings (e.g., further processing steps or end-of-line processing). Compared to a long high temperature treatment which is used in standard (conventional) RTA methods, the use of a millisecond annealing as described herein prevents mechanical relaxation at the high temperature and enables the maximum thermal stress build up. In an n-type FinFET device, the flow process described herein fully silicided the source/drain regions. It will be understood that the flow process described may instead be used to produce partially silicided structures (at the expense of efficiency) when so desired. The improved RTA process is compatible with standard FINFET/SOI process flows known to those skilled in the art.

The described flow process was also examined on a standard MOSFET. While the volume of silicided material formed was small and was generally not sufficient to greatly alter the stress (data not shown), the described flow process may still be applied to MOSFET devices, possibly in combination with another stressor.

Described herein are further flow processes for forming a FinFET structure having silicided source and drain regions.

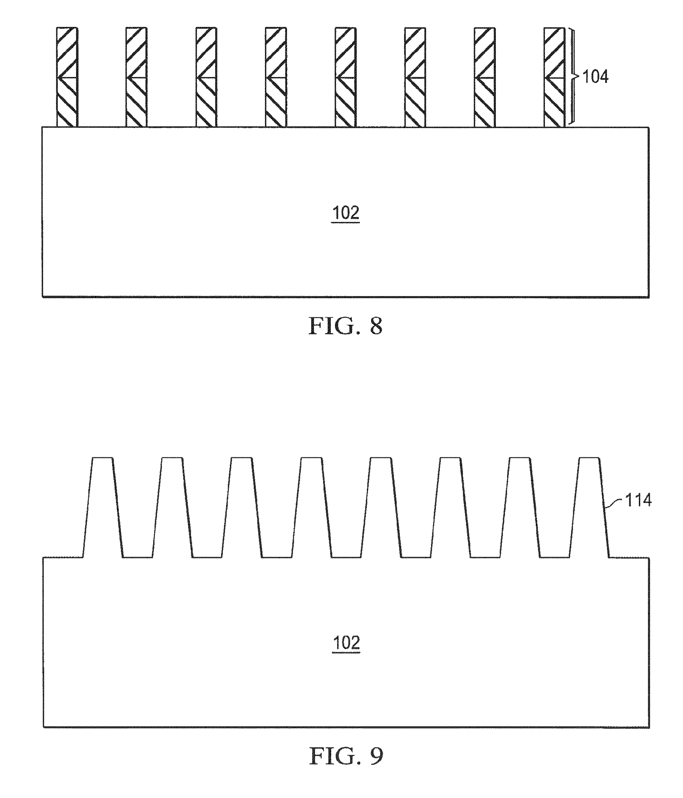

In some embodiments, the further flow process includes fully siliciding the source and drain regions of the structure after forming a metal gate, such as a high k metal gate. The process is represented schematically in FIGS. 8-20. For such a process, the flow includes: forming fins; optionally including an insulating field oxide (when forming on a bulk substrate); forming a dummy gate; forming spacers (optimized to maintain sufficient distance between the silicided region and the channel); forming the metal gate either following a gate first or a removal gate; performing the silicidation flow process described above (which includes depositing the metal/metal alloy, performing a first thermal annealing, and performing a second thermal annealing as a millisecond annealing); and completing transistor/circuit fabrication with standard subsequent processes known to those skilled in the art.

The further flow process may also include fully siliciding the source and drain regions before forming a metal gate, such as a high k metal gate. For such a process, the flow includes: forming fins; optionally including an insulating field oxide (when forming on a bulk substrate); forming a dummy gate; forming spacers (optimized to maintain sufficient distance between the silicided region and the channel); performing the silicidation flow process described above (which includes depositing the metal/metal alloy, performing a first thermal annealing, and performing a second thermal annealing as a millisecond annealing); forming the metal gate either following a gate first or a removal gate; completing transistor/circuit fabrication with standard subsequent processes known to those skilled in the art.

The further flow process of FIGS. 8-20 is now described. In Fig. 8, a patterned mask 104 is provided on top of a bulk semiconductor substrate 102. The mask 104 is a hard mask and may be an Si-containing material (or plurality of layers of Si-containing materials) or a photoresist layer. The substrate 102 may be a bulk substrate or alternatively may comprise a silicon on insulator (SOI) substrate. The semiconductor material may or may not be doped in accordance with the application.

A directional etching (e.g., high pressure directional etching; reactive ion etching) is then performed through the patterned mask 104 to remove semiconductor material of the substrate 102. The mask is then removed leaving a plurality of fins 114 on a top surface of the substrate 102. The etching is terminated before completely etching through substrate 102, thereby ensuring that formed fins 114 extend upward from the top surface of substrate 102. The result is illustrated in FIG. 9.

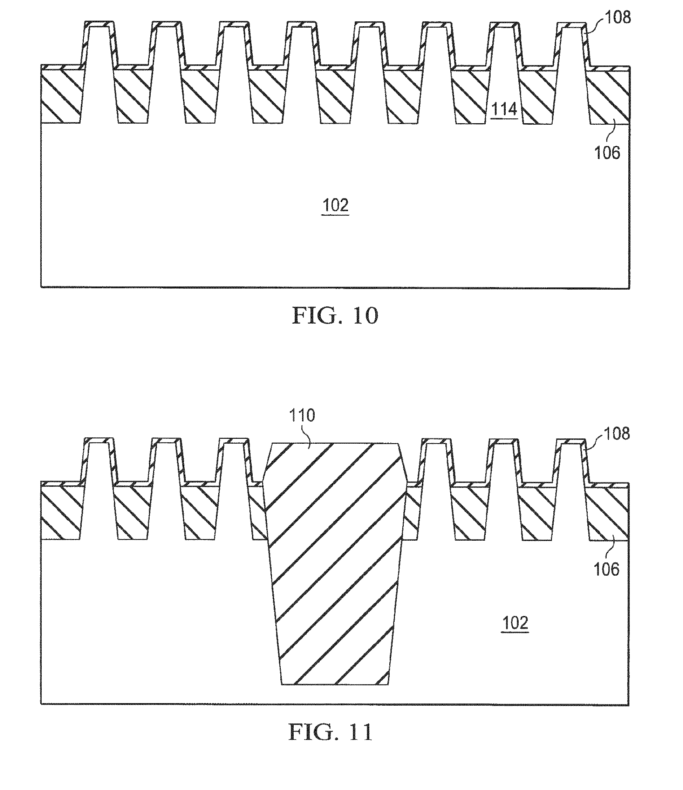

When substrate 102 is a bulk substrate, isolation regions 106, which are electrically inactive, are provided by deposition of an insulating field oxide material between fins to a height that is less than the height of the fin. This is shown in FIG. 10. A second insulation layer 108 is then deposited in a conformal manner on the wafer to cover both the isolation regions 106 and the extending fins 114. If the substrate is of the SOI type, or more generally when the substrate includes shallow trench isolation (STI) structures 110 between active regions of the substrate, the conformal second insulation layer 108 will also cover the STI structure 110. Those skilled in the art are familiar with the process of etching and filling a trench for the formation of STI structures 110 as well as the growth (for example, by epitaxy) of fins 114 from the top semiconductor layer of the SOI substrate. In one or more embodiments, the shallow trench isolation structures 110 are provided to isolate a first active region of the substrate from a second active region of the substrate. For example, the shallow trench isolation structures 110 may isolate a region for the formation of n-type devices from a region for the formation of p-type devices.

Dummy gate structures are formed either before or after silicidation in accordance with process described above in FIG. 1. The silicidation process includes depositing a metal/metal alloy, thermally annealing at a first temperature, removing unreacted metal and millisecond annealing at a second temperature.

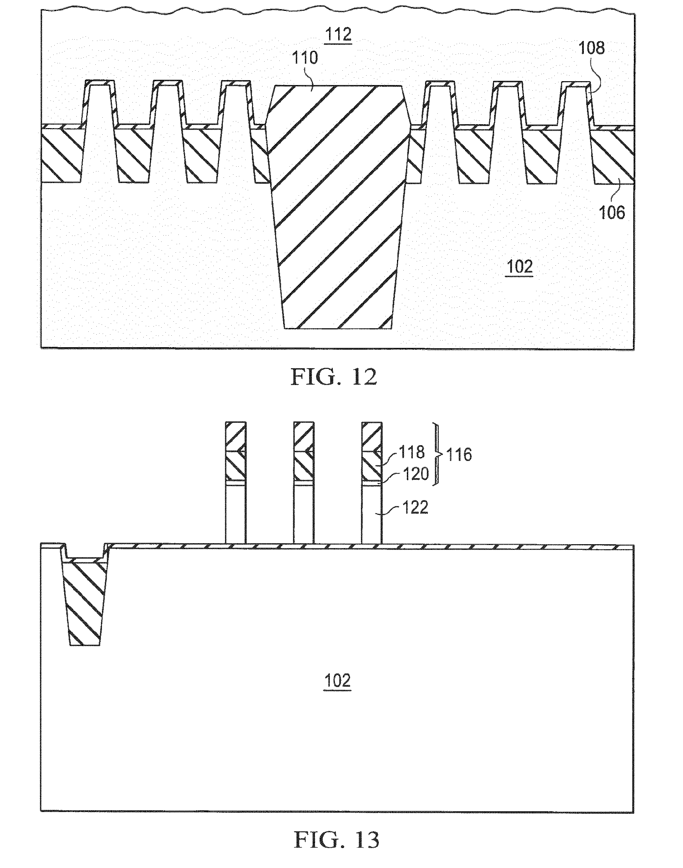

Dummy gates begin with deposition of a polysilicon layer 112 on the second insulation layer 108. This is shown in FIG. 12. The deposition process may be any known deposition process, including chemical vapor deposition (CVD), PVD, etc.

The polysilicon layer 112 is then masked with patterned mask 116 and the polysilicon material is selectively removed between the mask leaving a gate stack over the substrate comprising the dummy gate 122, layer 120 and cap 118. This is shown in FIG. 13.

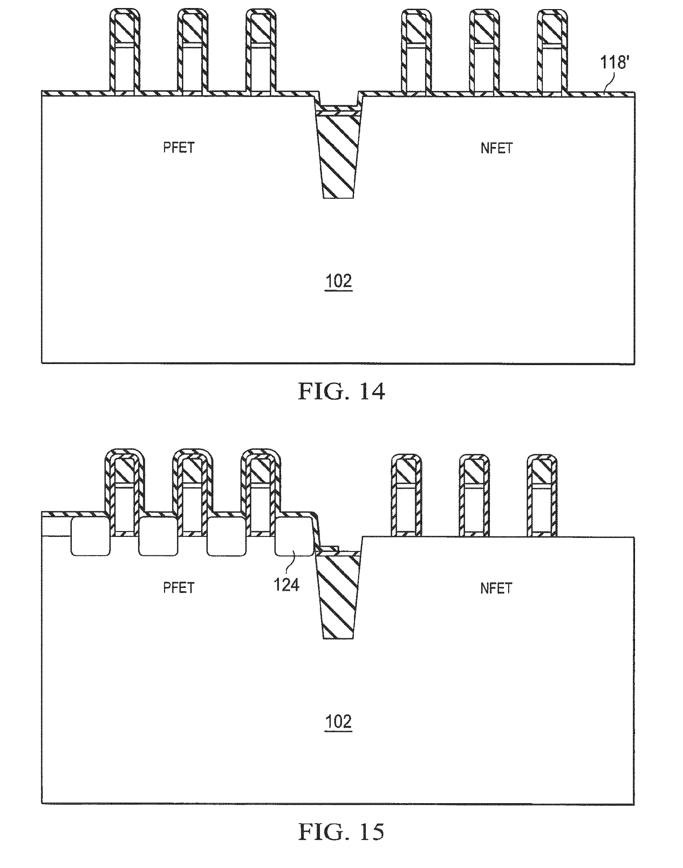

A conformal layer 118', of the same material as cap 118 (for example, silicon nitride), is then conformally deposited. This is shown in FIG. 14. The STI structure is shown separating the active region and dummy gates for the pFET devices from the active region and dummy gates for the nFET devices. Importantly, the conformal layer 118' is present on the sidewalls of the dummy gates.

An etch is then performed to remove the conformal layer 118' except for on the sidewalls of the dummy gates. The remaining portions of the conformal layer 118' form sidewall spacers for the gate electrodes.

The etch of the conformal layer 118' exposes the upper surface of the substrate. The active regions associated with nFET devices is masked off and an epitaxial process is performed in the active regions associated with the pFET devices to raised source-drain structures 124. This epitaxial growth may comprise silicon-germanium.

The mask over the active regions associated with the nFET devices is then removed. The result is shown in FIG. 15.

In an embodiment, epitaxial growth may also be performed to produce raised source-drain regions for the nFET devices. This epitaxial growth may comprise, for example, silicon-carbide. This is achieved by masking off the active regions associated with the pFET devices.

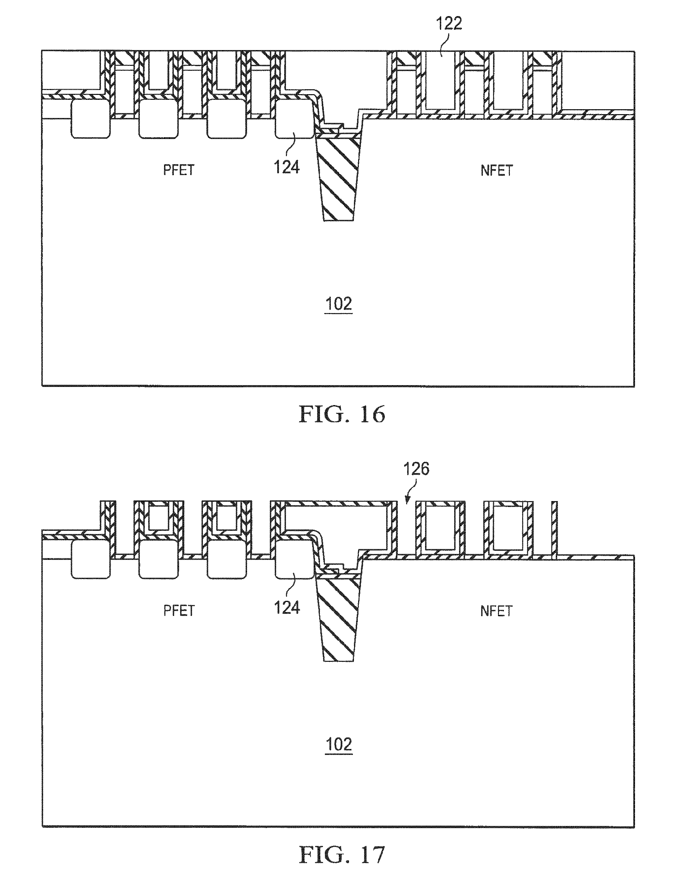

A conformal deposit of an insulating material layer is then provided over all structures and a pre-metal dielectric is deposited and subjected to planarization in a manner known to those skilled in the art. The planarization is performed to a point which exposes the polysilicon material of the dummy gate 122. The result is shown in FIG. 16.

The polysilicon material of the dummy gates 122 is then removed. This is shown in FIG. 17.

With the openings 126 provided by the removal of the dummy gates 122, gate stack materials are deposited to form a gate stack 128 comprising the following: a silicon nitride (Si₃N₄) and a hafnium-based oxide stack as the high permittivity dielectric, and a titanium-based alloy with tungsten as the gate metal stack which is capped with silicon nitride. Other gate stack materials and structures may be used comprising similar high permittivity oxides with other gate metals, such as aluminum alloys. Other capping materials are also suitable, for forming a high k dielectric gate.

The source-drain regions are provided within the fin on either side of the gate stack 128. Source/drain regions may be merged or unmerged.

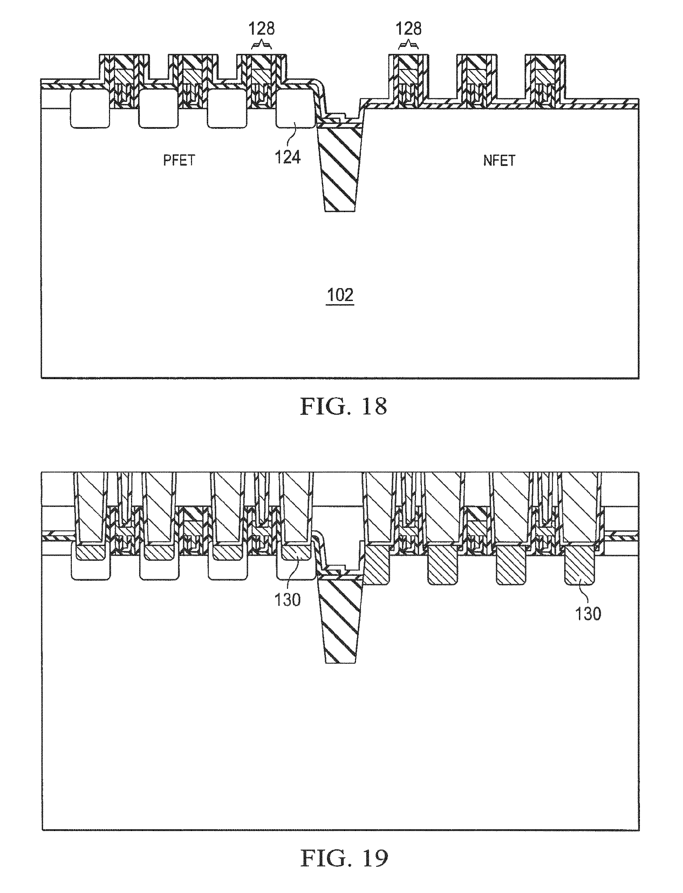

The source and drain regions are then silicided in accordance with the process of FIG. 1. The result is illustrated in FIG. 19 at regions 130. For example, a metal/metal alloy is deposited, a first thermal annealing at a first temperature is performed, unreacted metal/metal alloy is removed, and a second thermal annealing at the second millisecond annealing temperature is performed. With the improved flow processes described, the source-drain regions of nFET and pFET devices may be silicided in a common process step. Alternatively, a dual silicide scheme may be used or only one region may be silicided. Because the fins 114 are thin, there is no need for the improved flow process to include a significant annealing time in the millisecond annealing step in order to fully silicide the source drain regions. In the millisecond annealing step, the duration is 30 milliseconds or less, which also minimizes metal diffusion into the fins. While fully silicided source/drain regions are preferred, it will be understood that the processes described above could instead be used to produce partially silicided structures (at the expense of efficiency).

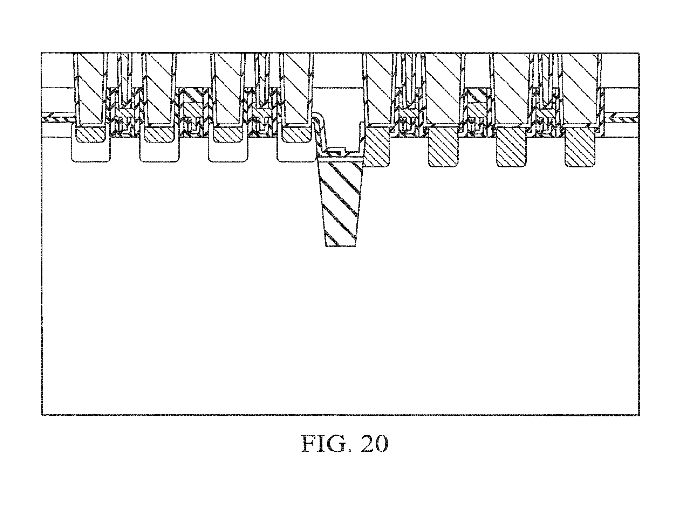

Standard processing of the structure may then be performed after performing the improved flow process in FIG. 19. The standard processing may produce contacts, vias, and interconnect features, such as a pre-metal dielectric layer, other metal layers and interlayer dielectrics, as required. See, FIG. 20. It is understood that the improved process flow described herein does not prevent formation of additional metallization layers above the structure, which may be formed in any manner well known to those skilled in the art.

A number of advantages accrue from the use of fully silicided source/drain regions obtained using the improved thermal annealing flow processes described. For example, the use of the millisecond annealing step facilitates siliciding of small surfaces. In addition, the millisecond annealing step un-wanted diffusion of any metal through a junction, which is detrimental to a semiconductor device. Additionally, the improved annealing processes described are much simpler to implement than embedding a stressor, such as embedding SiC as an *in situ* doped stressors.

FIGS. 14-20 show that the improved flow processes described are compatible with standard FINFET/SOI process flows known to those skilled in the art. While these figures illustrates a flow process for silicidation after gate formation, it is understood that silicidation of the source/drain regions may occur in a process flow either before or after gate formation.

The described improved process flow provides a semiconductor structure with strained channels induced by a tensile strain associated with silicidation of source/drain regions. The silicided source/drain regions will include a metal mono-silicide and it is the metal mono-silicide that introduces the tensile strain to the channel. The structure will further comprise spacers to maintain a sufficient distance between the silicided source/drain regions and the channel. Additional the structure will include a metal gate, such as a high k metal gate.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

## Claims

1. A process, comprising:
depositing a metal or metal alloy on a silicon-containing material;
thermally annealing at a first temperature;
removing unreacted metal or metal/alloy; and
thermally annealing at a second temperature and for a duration less than 30 milliseconds, wherein the second temperature is greater than the first temperature, and wherein the second temperature is a sub-melt temperature below a melt temperature of the silicon containing material.

2. The process of claim 1, wherein thermally annealing at the first temperature forms a metal rich phase in a portion of the silicon containing material.

3. The process of claim 1 or 2, wherein thermally annealing at the second temperature forms a metal mono-silicide in the silicon containing material.

4. The process of any of claims 1 to 3, wherein the first temperature is between about 250 °C and about 320° C and the second temperature is in excess of 650° C but below the melt temperature of the silicon containing material.

5. The process of any of claims 1 to 4, wherein the silicon-containing material is a source-drain region of a transistor.

6. The process of any of claims 1 to 5, wherein depositing comprises depositing a thin layer of the metal or metal alloy.

7. The process of any of claims 1 to 6, wherein the thermal annealing at the second temperature has a duration of less than 20 milliseconds.

8. The process of any of claims 1 to 7, wherein the thermal annealing at the second temperature has a duration of less than 10 milliseconds.

9. The process of any of claims 1 to 8, wherein the thermal annealing at the second temperature has a duration of about 1 millisecond to as low as 0.2 milliseconds.

10. The process of any of claims 1 to 9, wherein thermally annealing at a second temperature and for a duration less than 30 milliseconds comprises performing at least one of:
a millisecond sub-melt laser anneal;
a dynamic scanning anneal.

11. The process of any of claims 1 to 10, wherein thermally annealing at a first temperature comprises performing a rapid thermal anneal (RTA).

12. A process, comprising:
forming a silicon semiconductor structure supporting a source-drain region of a transistor;
forming a gate structure, said source-drain region provided in association with said gate structure;
siliciding said source-drain region by the process of any preceding claim.

13. The process of claims 12, wherein the silicon semiconductor structure is a fin of a FinFET transistor.

14. The process of any of claims 12 or 13, wherein the silicon semiconductor structure comprises silicon-germanium.

15. The process of any of claims 12 to 14, wherein the source-drain region is fully silicided.
